# EUROPÄISCHE PATENTSCHRIFT

(11) **EP 3 449 207 B1**
(45) Veröffentlichungstag und Bekanntmachung des Hinweises auf die Patenterteilung: **06.03.2024**
(21) Anmeldenummer: 17721567.0
(22) Anmeldetag: 25.04.2017
(51) Int. Cl.: G01B 11/02, B05B 12/00, B05B 12/08

(54) **VORRICHTUNG UND VERFAHREN ZUR VERMESSUNG EINES LACKSTRAHLS ZUM BESCHICHTEN VON PLATINEN**
DEVICE AND METHOD FOR MEASURING A PAINT JET FOR COATING CIRCUIT BOARDS
DISPOSITIF ET PROCÉDÉ POUR MESURER UN JET DE LAQUE POUR LE REVÊTEMENT DE CARTES DE CIRCUITS IMPRIMÉS

(30) Priorität: 25.04.2016 DE 102016206995
(43) Veröffentlichungstag der Anmeldung: 06.03.2019
(73) Patentinhaber: Rehm Thermal Systems GmbH, 89143 Blaubeuren-Seissen (DE)
(72) Erfinder: SCHWARZENBOLZ, Manuel David, 89134 Blaustein (DE)
(74) Vertreter: Grünecker Patent- und Rechtsanwälte PartG mbB
(86) Internationale Anmeldenummer: PCT/EP2017/059727
(87) Internationale Veröffentlichungsnummer: WO 2017/186678

(56) Entgegenhaltungen:
- WO-A1-2015/010806
- WO-A2-2010/107895
- DE-A1- 19 727 484
- DE-T2- 60 038 080
- SU-A1- 620 279
- US-A1- 2009 000 391

## Beschreibung

### Gebiet der Erfindung

Die vorliegende Erfindung betrifft allgemein die Vermessung eines Lackstrahls zum Beschichten von Platinen im Elektronikbereich, wo es auch als "Conformal Coating" bezeichnet wird, und betrifft einen optischen Sensor, der zum Vermessen eines Lackstrahls zum Beschichten von Platinen, angepasst ist, eine Messvorrichtung, die diesen optischen Sensor verwendet, eine Lackiervorrichtung für Platinen, die diese Messvorrichtung verwendet, ein Verfahren zur Bestimmung von Breite bzw. Symmetrie eines Lackstrahls zum Beschichten von Platinen, und ein Verfahren zum Einmessen eines Lackstrahls.

### Hintergrund der Erfindung

Bei der Herstellung von elektronischen Baugruppen werden die Platinen häufig nach der Bestückung mit elektronischen Bauteilen mit einem Schutzlack versehen. Diese Form der Beschichtung wird auch "Conformal Coating" genannt, da sie konform zur Oberflächenstruktur oder -topologie ist. Bei der Beschichtung werden bestimmte Bereiche, wie beispielsweise Kontaktpunkte, Steckerleisten usw., ausgespart, so dass der Beschichtungsvorgang selektiv und präzise erfolgen muss. Dazu sind aus dem Stand der Technik Flüssigkeitsabgabesysteme bekannt, mit denen ein Flüssigkeitsstrahl in einem bestimmten Flüssigkeitssprühmuster gemäß einem definierten Lackierplan von einem Düsenauslass in Richtung einer zu beschichtenden Oberfläche abgegeben wird. Weit verbreitete Anwendung findet dabei ein System, das einen Applikator verwendet, der einen fächerförmigen Flüssigkeitsstrahl abgeben kann. Ein solchermaßen geformter Flüssigkeitsstrahl wird als Vorhang bezeichnet, der durch eine entsprechend ausgeformte Düse im Applikator, die im Folgenden als Vorhangdüse, Applikatordüse oder einfach als Düse bezeichnet wird, ausgebildet werden kann. Die wirksame Applikationsbreite des Vorhangs hängt von dem Versorgungsdruck für die applizierte Flüssigkeit, in diesem Fall ein Schutzlack, der Düsengeometrie und der verwendeten Applikationshöhe ab, d.h. dem Abstand zwischen dem Auslass der Vorhangdüse und der zu beschichtenden Oberfläche.

Vor der Verwendung in einem Beschichtungsvorgang muss die Düse bzw. der Flüssigkeitsvorhang eingemessen werden, d.h. es muss ein Druck bestimmt werden, mit dem die Flüssigkeit, beispielsweise ein Schutzlack, der Düse zugeführt werden muss, um beim Austreten aus der Düsengeometrie eine bestimmte Breite des Flüssigkeitsvorhangs bzw des Lackvorhangs in einer bestimmten Applikationshöhe zu erreichen. Weiterhin muss die Symmetrie des Lackvorhangs bestimmt werden, da die Düsen Toleranzen aufweisen, bzw. verschmutzen können, und sich dadurch ein unsymmetrischer Flüssigkeitsstrahl ausbilden kann. Beim Einmessen werden die Parameter bestimmt, mit denen dann der Beschichtungsvorgang stattfinden soll, d.h. bei welcher Applikationshöhe soll die Beschichtung stattfinden, welcher Versorgungsdruck muss verwendet werden, um eine bestimmte Vorhangbreite in der gewünschten Applikationshöhe zu erreichen, und es muss bestimmt werden, ob aufgrund von Toleranzen, Abnutzung der Vorhangdüse und möglichen Verschmutzungen eine Asymmetrie des Vorhangs besteht, so dass der definierte Lackierplan mit den Positionen des Applikators während des Beschichtungsvorganges entsprechend korrigiert werden kann, um das vorgesehene Sprühmuster zu erhalten. D. h., im Falle einer Asymmetrie ist der Lackvorhang nicht mehr symmetrisch zur Düsenmündung und die Positionierung der Vorhangdüse während des Lackiervorgangs muss entsprechend der Asymmetrie korrigiert werden.

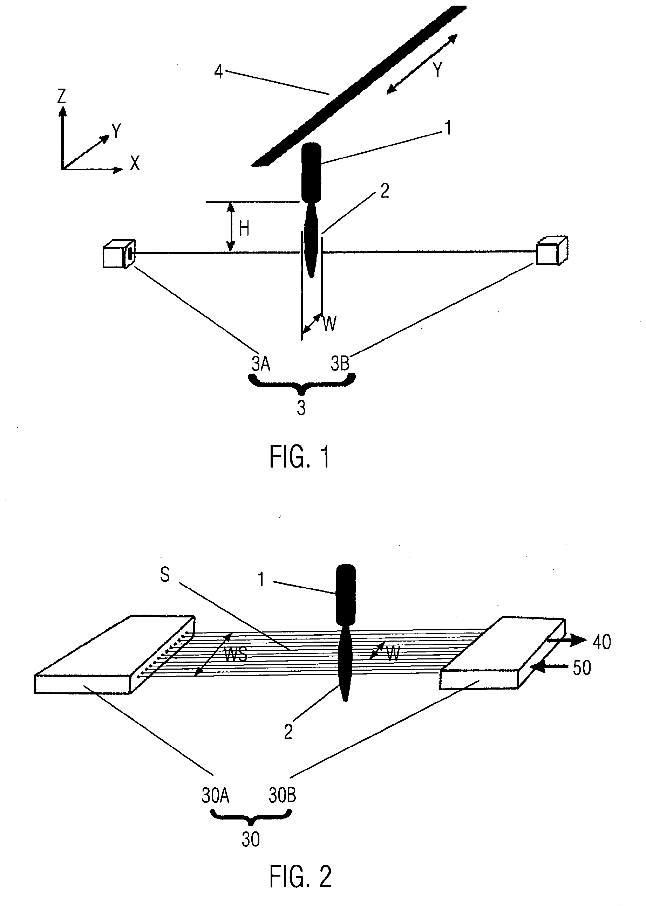

Für den Einmessvorgang bzw. für das Ausmessen der Vorhanggeometrie wird im Allgemeinen eine Einmessstation in der Lackiervorrichtung mit einem optischen Sensor verwendet. Eine solche Messanordnung gemäß dem Stand der Technik wird in Fig. 1 gezeigt. In Fig. 1 wird mit dem Bezugszeichen 1 schematisch die Vorhangdüse gezeigt, Bezugszeichen 2 bezeichnet den Lackvorhang, das Bezugszeichen 4 bezeichnet eine Transportvorrichtung für die Vorhangdüse 1, das Bezugszeichen 3 bezeichnet den Sensor, das Bezugszeichen H bezeichnet die Applikationshöhe und das Bezugszeichen W bezeichnet die Breite des Lackvorhangs 2. Die Transportvorrichtung 4 für den Applikator kann die Vorhangdüse 1 in der in Fig.1 gewählten Darstellungsform in y-Richtung an dem Sensor vorbeifahren. Die Breitenrichtung der Breite W des Lackvorhangs 2 erstreckt sich ebenfalls in y-Richtung. Die Höhenrichtung der Applikationshöhe H erstreckt sich in der in Fig. 1 gewählten Darstellung senkrecht zur Bewegungsrichtung der Transportvorrichtung 4 in z-Richtung. Die Messrichtung des Sensors 3, die der Ausbreitungsrichtung des Detektor Lichtstrahl entspricht, erstreckt sich senkrecht zur Bewegungsrichtung der Transportvorrichtung 4 (y-Richtung) und senkrecht zur Höhenrichtung (z-Richtung) in x-Richtung. Der optische Sensor besteht aus einer im Wesentlichen punktförmigen Lichtquelle 3A und einem Empfänger 3B, beispielsweise eine Photodiode. Sender und Empfänger können als Unterbrecher angeordnet sein in Form einer Lichtschranke, oder Sender und Empfänger können auch miteinander integriert sein, wobei der Empfänger das vom Sender emittierte Licht nicht direkt, sondern als an einem Objekt reflektiertes Licht empfängt. Zum Einmessen des Lackvorhangs wird die Vorhangdüse zunächst in den Sensorbereich bewegt. Danach wird der Applikator aktiviert und Lack wird unter einem vorgegebenen Druck durch die Düsenmündung ausgegeben. Während die spezielle Düse den Lackvorhang produziert wird diese spezielle Düse (Vorhangdüse) an dem optischen Sensor in der gewünschten Applikationshöhe vorbeigeführt. Aus der Geschwindigkeit der Vorhangdüse relativ zum optischen Sensor sowie Anfang und Beginn der Unterbrechung bzw. Reflexion des Lichtstrahls wird die Vorhangbreite in der erforderlichen Applikationshöhe bestimmt.

Messsysteme dieser Art werden beispielsweise in der DE 600 38 080 T2 und der EP 1 432 526 beschrieben.

Das Dokument US 2009/000391 A1 betrifft ein Verfahren und eine Vorrichtung zur Messung einer austretenden Flüssigkeit, bei dem austretende Flüssigkeit einen Signalstrahl kreuzt, wobei die Signalstrahlbreite größer ist als die Auslassöffnung für die austretende Flüssigkeit.

Das Dokument WO 2015/010806 A1 betrifft ein Auftragssystem und Auftragsverfahren für eine pasteuse Masse, das eine optische Überwachungsvorrichtung zur Überwachung der Massestrahlrichtung aufweist. Dazu werden zwei sich kreuzende Laserstrahlen verwendet, die abgeschattet werden, wenn sich der Massestrahl in der Sollrichtung befindet.

Das Dokument SU 620279 A1 betrifft eine Vorrichtung zum Sprühtrocknen, wobei mit Hilfe von vier Lichtstrahlen die korrekte Funktion der Austrittsdüse überwacht werden kann.

Das Dokument WO 2010/107895 betrifft eine Vorrichtung und ein Verfahren zur Messung eines Sprühwinkels. Dazu wird ein planarer Laserstrahl verwendet, der eine nicht invasive Beleuchtungsebene erzeugt, durch den der Sprühnebel hindurchtritt. Eine Kamera erfasst das vom Sprühnebel gestreute Licht und ein Prozessor bestimmt aus den aufgenommenen Bildern eine Emissionsrichtung.

DE 197 27 484 A1 betrifft ein Verfahren und eine Vorrichtung zum Vermessen eines aus einer Sprühdüse austretenden Sprühstrahls zur Lackierung einer Türinnenverkleidung.

Diese Arten der Vermessung der Vorhangbreite haben den Nachteil, dass die Vorhangdüse während des Messvorgangs bewegt werden muss und somit Positionierfehler des Schrittmotors für die Verschiebung der Vorhangdüse kumulieren können und zu Ungenauigkeiten bei der Bestimmung der Vorhangbreite führen können. Weiterhin dauert der Messprozess lang und während des gesamten Bewegungsablaufs kann es notwendig sein, dass Lack durch die Düse ausgestoßen wird, was zu einem hohen Lackverbrauch führt.

Es ist wünschenswert, eine genauere und schnellere Messvorrichtung bereitzustellen. Es ist deshalb eine Aufgabe der vorliegenden Erfindung, Vorrichtungen und Verfahren bereitzustellen, mit denen ein Lackstrahl schnell, präzise und damit kostengünstig für die Platinenherstellung vermessen und eingemessen werden können.

### Zusammenfassung der Erfindung

Die Aufgabe wird erfüllt durch eine Lackiervorrichtung gemäß Anspruch 1 und ein Verfahren gemäß Anspruch 6. Die Lackiervorrichtung der vorliegenden Erfindung umfasst einen optischen Sensor, der zum Vermessen eines Lackstrahls für einen Lackierprozess, insbesondere einen Conformal Coating Prozess, angepasst ist, wobei der optische Sensor umfasst:
ein Sichtfeld das eine Breitenausdehnung aufweist, die größer ist als die maximal zu erwartende Breite des Lackstrahls, so dass der Sensor relativ zum Lackstrahl während des Messvorgangs nicht bewegt werden muss; mindestens zwei Ausgänge, wobei der optische Sensor einen ersten Betriebsmodus und einen zweiten Betriebsmodus aufweist, wobei im ersten Betriebsmodus über den mindestens einen Ausgang ein Signal ausgegeben werden kann, das mit einer Breite des Lackstrahls im Sichtfeld des optischen Sensors korrespondiert, und wobei im zweiten Betriebsmodus über den mindestens einen Ausgang (40) ein Signal ausgegeben werden kann, das mit einer Position einer Mittellage des Lackstrahls relativ zum optischen Sensor korrespondiert.

Der so gestaltete optische Sensor erlaubt eine einfache Bestimmung sowohl der Breite eines Lackstrahls als auch dessen Symmetrie, ohne dass eine relative Bewegung zwischen Lackstrahl und Sensor nötig ist.

Auf dem ersten der mindestens zwei Ausgänge kann ein Signal ausgegeben werden, das mit der Breite des Lackstrahls im Sichtfeld des optischen Sensors korrespondiert. Auf dem zweiten der mindestens zwei Ausgänge kann ein Signal ausgegeben werden, das mit der Position der Mittellage des Lackstrahls relativ zum optischen Sensor korrespondiert. Eine Komplettvermessung des Lackstrahls kann so schnell durchgeführt werden, da beide Parameter gleichzeitig und in Echtzeit bereitstehen.

Bei Verwendung eines analogen Ausgangs erlaubt der optische Sensor auch eine einfache Nachrüstung von älteren und einfacheren Beschichtungsanlagen. Beispielsweise kann ein analoger Ausgang ein analoges Ausgangssignal im Spannungsbereich von 0 - 10 Volt oder -5 - +5 Volt, bzw. Im Strombereich 0 - 20 mA oder 4 - 20 mA ausgeben. Diese Spannungs- bzw. Strombereiche lassen sich mit gängigen Erfassungs- und Auswerteeinrichungen bearbeiten.

Um die Lackstrahlbreitenmessung ohne Bewegung des Lackapplikators durchführen zu können, ist es vorteilhaft, wenn der optische Sensor ein Sichtfeld mit einer Breitenausdehung aufweist, die größer ist als die maximal zu erwartende Breite des Lackstrahls. Beispielsweise werden in gängigen Lackieranlagen Applikatoren für eine Vorhangbreite zwischen 0,3 cm und 2 cm verwendet, so dass das Sichtfeld des optischen Sensors im Bereich 1 cm bis 4 cm, vorzugsweise im Bereich von 3 cm, liegen sollte.

In einer weiteren Ausführungsform verwendet der optische Sensor Licht in einem Wellenlängenbereich von 650 nm bis 780 nm, vorzugsweise in einem Bereich um 670 nm. In einem solchen Wellenlängenbereich erhält man auch für die beim "Conformal Coating" verwendeten transparenten Lacke einen besseren Kontrast zur Durchführung der Messung. Der Wellenlängenbereich um 670 nm hat den Vorteil, dass er einen besonders guten Kompromiss zwischen erreichbarem Kontrast und Kosten für die Lichtquelle bietet.

Die Lackiervorrichtung umfasst weiterhin eine Messvorrichtung, die Folgendes umfasst: den vorher genannten optischen Sensor; eine Positioniereinrichtung, die zum Positionieren eines Lackapplikators für das Beschichten von Platinen mit Schutzlack angepaßt ist; und eine Steuerungseinrichtung, die konfiguriert ist, die Positioniervorrichtung so zu steuern, dass der Lackapplikator an eine vorgegebene Messposition befördert wird, so dass ein Lackaustritt aus der Düsenmündung der Vorhangdüse im Applikator in einer vorgegebenen Applikationshöhe oberhalb des Sichtfelds des Sensors positioniert wird, und eine Lackstrahlbreite und/oder eine Lackstrahlsymmetrie des Lackstrahls in der vorgegebenen Applikationshöhe gemessen werden kann.

Eine dergestalt ausgebildete Messvorrichtung lässt sich leicht in eine Lackiervorrichtung für Platinen integrieren und das Einmessen der Breite eines Lackstrahs für einen Lackapplikator bzw. eine Vorhangdüse kann als Teil des Lackierprozesses realisiert werden.

Weiterhin umfasst die Messvorrichtung eine Lackversorgungseinrichtung, wobei die Steuerungseinrichtung konfiguriert ist, die Lackversorgungseinrichtung anzusteuern, so dass die Lackstrahlbreite und/oder die Lackstrahlsymmetrie des Lackstrahls bei einem bestimmten Versorgungsdruck für den Lack bestimmt werden kann. Mit einer Lackversorgungseinrichtung als Teil der Messvorrichtung ist die Messvorrichtung universeller einsetzbar, beispielsweise als unabhängiger Prüfstand für lackstrahlabgebende Applikatoren oder als integraler Teil einer Lackiervorrichtung für Platinen, wobei die Steuerungseinrichtung und die Lackversorgungseinrichtung dieser Messvorrichtung den Lackiervorgang an sich in der Lackiervorrichtung für Platinen umsetzen können.

Die Positioniervorrichtung der Messvorrichtung ist dabei weiterhin konfiguriert, den Applikator mit der Vorhangdüse in den Lackierbereich zu positionieren und im Lackierbereich so zu bewegen, dass die Platine mit dem definierten Lackierplan lackiert wird. Weiterhin ist die Steuerungseinrichtung der Messvorrichtung in der Lackiervorrichtung konfiguriert, die Positioniervorrichtung und die Lackversorgungseinrichtung für einen Lackiervorgang unter Verwendung der gemessenen Lackstrahlbreite mit dem dazu gehörenden Versorgungsdruck und der gemessenen Lackstrahlsymmetrie zu steuern.

Durch die in der Lackiervorrichtung integrierte Messvorrichtung mit dem erfindungsgemäßen Sensor ist es möglich, Platinen selektiv mit einem Schutzlack zu beschichten und dabei besondere Bereiche, wie beispielsweise Steckerleisten und Anschlüsse, frei zu lassen. Durch die präzise Einmessung, die mit der erfinderischen Lackiervorrichtung möglich ist, können die Lackierbahnen so präzise gesetzt werden, dass keine Maskierungsarbeiten notwendig sind und trotzdem eine gleichmäßige Schutzschicht an Überlappungsstellen der Bahnen bei gleichzeitig sparsamen Lackverbrauch realisiert werden kann.

Die Aufgabe auch durch ein Verfahren gemäß Anspruch 6 zum Betreiben der Lackiervorrichtung gemäß Anspruch 1 gelöst. In einer Ausführungsform umfasst das Verfahren die folgenden Schritte: Bewegen eines Lackpplikators zu einer Messposition einer Lackiervorrichtung für Platinen; Zuführen von Lack unter einem vorgegebenen Druck zum Applikator; Erfassen der Strahlbreite mit dem optischen Sensor wie er oben beschrieben wurde, während der Lackapplikator stillsteht; und Ausgeben eines ersten Signals, das mit der Breite des Lackstrahls korrespondiert.

Mit diesem Verfahren kann die Breite eines Lackstrahls bzw. Lackvorhangs schnell und präzise bestimmt werden. Dieses Verfahren kann als Strahlbreitencheck zwischendurch durchgeführt werden, beispielsweise nach jedem oder jedem zweiten, dritten etc. fertiggestellten Substrat, beispielsweise einer bestückten Platine. Das Verfahren kann aber auch für ein Einmessverfahren verwendet werden, bei dem ein Versorgungsdruck für eine bestimmte Strahlbreite ermittelt wird.

In einer Ausführungsform nach Anspruch 8 umfasst das Verfahren die folgenden Schritte: Bewegen eines Lackapplikators zu einer Messposition einer Lackiervorrichtung für Platinen; Zuführen von Lack unter einem vorgegebenen Druck zum Lackapplikator; Erfassen einer Mittellage des Lackstrahls relativ zum optischen Sensor mit dem optischen Sensor, während der Lackapplikator stillsteht; Ausgeben eines zweiten Signals, das mit einer Position einer Mittellage des Lackstrahls relativ zum optischen Sensor korrespondiert; Vergleichen der Position der Mittellage des Lackvorhangs mit der Mittenposition einer Düsenmündung im Lackapplikator; und Bestimmen des Abstandes der beiden Positionen als Maß der Asymmetrie des Lackstrahls.

Mit diesem Verfahren kann schnell und präzise die Asymmetrie des Lackstrahls bestimmt werden, so dass auf einfache Weise Korrekturen für das Positionieren des Lackapplikators beim Beschichten der Platinen vorgenommen werden können. Dieses Verfahren kann als Symmetriecheck zwischendurch durchgeführt werden, beispielsweise nach jedem oder jedem zweiten, dritten etc. fertiggestellten Substrat, beispielsweise einer bestückten Platine, um festzustellen, ob eine Reinigung der Düse nötig ist, oder ob der Lackierplan angepasst werden muss. Das Verfahren kann aber auch für ein Einmessverfahren verwendet werden, bei dem nach der Bestimmung eines Versorgungsdrucks für eine bestimmte Strahlbreite die Symmetriedaten ermittelt werden. In einer weiteren Ausführungsform der vorher genannten Verfahren wird der Lackapplikator so an der Messposition positioniert, dass ein Lackaustritt aus einer Düsenmündung im Lackapplikator in einer vorgegebenen Applikationshöhe oberhalb eines Sichtfelds des Sensors positioniert wird, und dass eine Lackstrahlbreite und/oder eine Vorhangsymmetrie des Lackvorhangs in der vorgegebenen Applikationshöhe gemessen werden können.

In einer Ausführungsform, die in Anspruch 10 beansprucht wird, umfasst das Verfahren die Schritte,
(a) Einstellen des Versorgungsdrucks für den Lack auf einen Anfangswert;
(b) Bestimmen einer Breite eines Lackstrahls für eine gewünschte Applikationshöhe gemäß dem sechsten Aspekt;
(c) Vergleich der gemessenen Lackstrahlbreite mit einem Sollwert;
(d) Anpassen des Versorgungsdrucks für den Lack um einen vorgegebenen Betrag, wenn die gemessene Lackstrahlbreite nicht der Solllackstrahlbreite entspricht;
(e) Wiederholen der Schritte (b) bis (d), bis die Solllackstrahlbreite erreicht ist; und
(f) Abspeichern des Werts für erreichten Versorgungsdruck.

Mit diesem Verfahren erhält man schnell und lacksparend den erforderlichen Versorgungsdruck für die Lackapplikation bei einer gewünschten Applikationshöhe.

Gemäß einem weiteren Aspekt der vorliegenden Erfindung wird die Aufgabe durch ein Verfahren nach Anspruch 11 gelöst.

Mit diesem Verfahren erhält man Korrekturwerte bei Asymmetrien des Lackvorhangs aufgrund von Verschleiß- und Fertigungstoleranzen der Vorhangdüse, die zur Weiterverarbeitung bei der Erstellung oder Änderung eines Lackierplans verwendet werden können. Dieses Verfahren kann im Anschluss an das Einmessverfahren gemäß dem achten Aspekt der vorliegenden Erfindung angewendet werden. Es kann aber auch als Symmetriecheck nach dem Verfahren gemäß dem Anspruch 10 der vorliegenden Erfindung verwendet werden. Der abgespeicherte Wert kann später bei der Erstellung oder der Korrektur des Lackierplans verwendet werden. Beispielsweise kann eine Null als abgespeicherter Wert bedeuten, dass keine Asymmetrie vorliegt.

In einer Ausführungsform umfasst das Verfahren die Schritte:
(i) Bestimmen der Asymmetrie des Lackstrahls gemäß der Ausführung nach Anspruch 8 der vorliegenden Erfindung;
(j) Vergleich des Abstandes zwischen der Position der Mittellage des Lackstrahls und der Mittenposition der Düsenmündung am Lackapplikator mit einem ersten Schwellwert; und
(k) Abspeichern der Asymmetrie in Form eines Wertes für einen Versatz zwischen der Position der Mittellage des Lackvorhangs und der Mittenposition der Düsenmündung am Lackapplikator, wenn der erste Schwellwert überschritten wird.

Zusätzlich zur Ausführungsform nach Anspruch 10 der vorliegenden Erfindung wird in diesem Verfahren abgeklärt, ob überhaupt eine Korrektur des Lackierplans nötig wäre. Je nach ermittelter Asymmetrie könnte bestimmt werden, wann der nächste Symmetriecheck stattfinden soll.

In einer Ausführungsform kann der Abstand zwischen der Position der Mittellage des Lackstrahls und der Mittenposition der Düsenmündung am Lackapplikator mit einem zweiten Schwellwert verglichen werden, und wenn der zweite Schwellwert überschritten wird, kann der Lackapplikator in eine Reinigungsposition positioniert werden und eine Reinigung kann durchgeführt werden. Bei Misslingen des Reinigungsvorgangs muss die Düse ausgetauscht werden um die Qualität der Beschichtung beizubehalten.

### Kurze Beschreibung der Zeichnungen

Im Folgenden werden Ausführungsbeispiele, Weiterbildungen, Vorteile und Anwendungsmöglichkeiten der Erfindung anhand der beigefügten Figuren näher erläutert. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht. In den Figuren zeigt:
- Fig. 1: eine Sensoranordnung zur Vermessung der Vorhangbreite gemäß dem Stand der Technik;
- Fig. 2: eine Sensoranordnung zur Vermessung einer Vorhangbreite gemäß der vorliegenden Erfindung;
- Fig. 3: eine Querschnittsansicht der Anordnung von Fig. 2;
- Fig. 4: ein Beispiel für einen symmetrischen Lackvorhang;
- Fig. 5: ein Beispiel für einen unsymmetrischen Lackvorhang;
- Fig. 6: eine schematische Darstellung für einen Teilabschnitt einer Platinenfertigungsanlage;
- Fig. 7: ein Flussdiagramm eines Verfahrens zur Bestimmung der Breite eines Lackvorhangs;
- Fig. 8: ein Flussdiagramm eines Verfahrens zur Bestimmung der Asymmetrie eines Lackvorhangs;
- Fig. 9: ein Flussdiagramm für ein Verfahren zum Einmessen einer Breite eines Lackvorhangs; und
- Fig. 10: ein Flussdiagramm für ein Verfahren zum Einmessen der Asymmetrie eines Lackvorhangs.

### Ausführliche Beschreibung der Erfindung

Fig. 2 zeigt eine schematische Darstellung eines Beispiels für eine Sensoranordnung zum Vermessen der Breite eines Lackvorhangs gemäß der vorliegenden Erfindung. Obwohl in der detaillierten Beschreibung die Begriffe "Lackvorhang", "Vorhangbreite", "Vorhangsymmetrie" und "Vorhangdüse" verwendet werden, sollte man verstehen, dass diese Begriffe beispielhaft zur Veranschaulichung in einer spezielle Ausführungsform verwendet werden, und diese Begriffe durch die allgemeineren Begriffe und Merkmale "Lackstrahl", "Lackstrahlbreite", "Lackstrahlsymmetrie" und "Lackapplikator" ersetzt werden können.

Fig. 2 zeigt schematisch eine Vorhangdüse 1, einen Lackvorhang 2 und einen Sensor 30 bestehend aus einem Sender 30A und einem Empfänger 30B. Der Empfänger verfügt über einen analogen Ausgang 40 und einen digitalen Eingang 50. Der Sensor 30 ist hier als ein Lichtschrankenarray dargestellt mit einem Senderabschnitt 30A und einem Empfängerabschnitt 30B. Der Senderabschnitt 30A kann beispielsweise ein lineares Array aus Laserdioden sein, und der Empfängerabschnitt 30B kann ein lineares Array aus Empfängerdioden sein. Der besondere Aufbau des Sensors 30 ist jedoch nicht von Bedeutung. Die erfinderischen Vorteile ergeben sich aus der Sensorstruktur, mit der die gesamte Breite eines Lackvorhangs erfasst werden kann und sowohl dessen Breite als auch dessen Asymmetrie über mindestens einen Ausgang ausgegeben werden kann. Diese Funktion ließe sich beispielsweise auch mit einem Laserstrahl und einer Empfängerdiode erfüllen, wobei der Laserstrahl mittels beweglichen Mikrooptiken geformt und auf die Photodiode gelenkt wird, so dass beispielsweise eine sehr schnelle Abtastung des Lackvorhangs erfolgen kann. Ebenso ist die Anordnung als Unterbrechersystem (Lichtschrankenprinzip) mit gegenüber liegendem Sender und Empfänger, wie in Fig. 2 gezeigt wird, nicht nötig. Der Sensor kann auch integrierte Sender/Empfängereinheit mit und ohne gegenüberliegendem Reflektor realisiert werden. Auch die Darstellung mit einem digitalen Eingang und einem analogen Ausgang ist nur beispielhaft. Es können auch mehrere Ausgänge verwendet werden, so dass Symmetriedaten und Daten zur Breite des Lackstrahls gleichzeitig ausgegeben werden können. Es können auch mehrere Eingänge vorhanden sein oder es kann auf den Eingang verzichtet werden. Die Ein- und Ausgänge können analog und/oder digital sein. Die Darstellung in den Figuren soll deshalb nur als ein Beispiel zur Ausführung der Erfindung angesehen werden.

Eine wesentliche Eigenschaft des Sensors 30 ist, dass er ein Sichtfeld S mit einer effektiven Breite WS aufweist, die größer als die Breite W des Lackvorhangs 2 ist, so dass die Breite W des Lackvorhangs 2 ohne Bewegung des Lackvorhangs relativ zum Sensor erfasst werden kann. Bei Verwendung des gleichen Koordinatensystems wie in Fig. 1 erstreckt sich deshalb die Breitenrichtung der Breite WS des Sichtfelds in y-Richtung. Die Breitenrichtung der Breite W des Lackvorhangs 2 erstreckt sich ebenfalls in y-Richtung. Da die Breite WS des Sichtfelds S größer ist als die Breite W des Lackvorhangs 2, kann die Breite W des Lackvorhangs 2 ohne Bewegung der Vorhangdüse 1 erfasst werden.

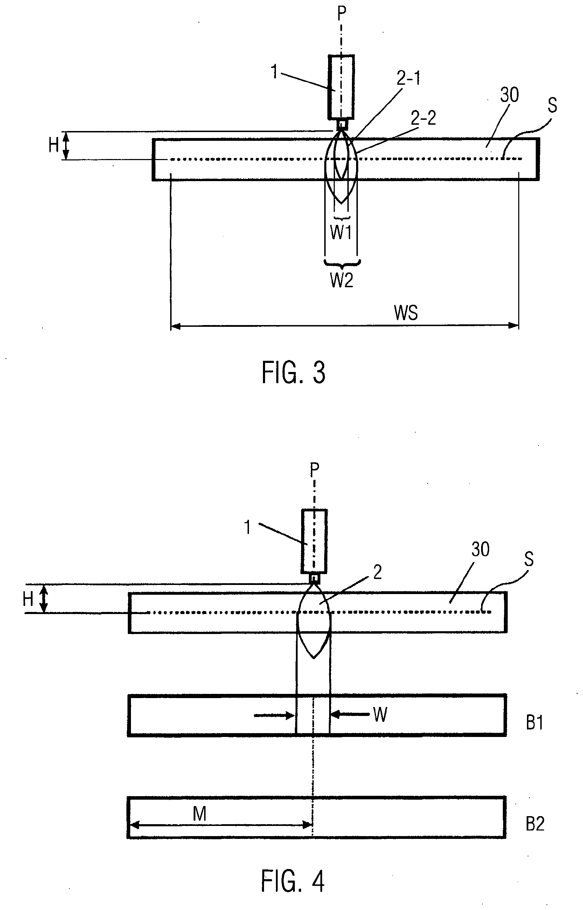

Fig. 3 veranschaulicht die Wirkung von unterschiedlichen Versorgungsdrücken für die Vorhangdüse 1. Fig. 3 ist eine Querschnittsansicht der 3D-Ansicht von Fig. 2 mit einer Blickrichtung in x-Richtung. Das Bezugszeichen P bezeichnet die Ortslage der Vorhangdüse 1 in der Messposition. In dem von den Fig. 1, 2 und 3 gewählten Koordinatensystem entspricht die Messposition P einer festgelegten y-Koordinate. Fig. 3 zeigt zwei verschiedene Lackvorhänge 2-1 und 2-2, die bei unterschiedlichen Versorgungsdrücken für die Zuführung von beispielsweise Schutzlack zur Vorhangdüse 1 entstehen. In dem in Fig. 3 gezeigten Beispiel weist der erste Lackvorhang 2-1 eine Breite W1 auf, die durch einen ersten Versorgungsdruck erreicht wird. Der zweite Lackvorhang 2-2 erreicht bei einem zweiten Versorgungsdruck, der größer ist als der erste Versorgungsdruck eine Breite W2, die größer ist als die erste Breite W1. Die Breite wird gemessen im Sichtfeld S des Sensors 30. Das Sichtfeld S erstreckt sich in dem in den Fig. 1 bis 3 gewählten Koordinatensystem in y-Richtung und weist in Höhenrichtung (z-Richtung) eine vernachlässigbare Ausdehnung auf. Die Vorhangdüse 1 befindet sich in der gewählten Applikationshöhe H über dem Sichtfeld S (z-Richtung). Die Breiten W1 und W2 werden im Sichtfeld S des Sensors 30 gemessen, d.h. auf der Linie des Sichtfeldes S. Wie in Fig. 3 zu sehen ist, ist die Breite WS des Sichtfeldes S größer als die Breiten des Lackvorhangs W1 und W2. Die Breite WS des Sichtfeldes S wird so gewählt, dass sie größer ist als die maximal zu erwartende Breite W des Lackvorhangs 2.

Fig. 4 veranschaulicht das Einmessprinzip der vorliegenden Erfindung. Der Block 30 veranschaulicht den Sensor und die Blöcke B1 und B2 veranschaulichen die Betriebsmodi des Sensors 30. In den Betriebsmodi B1 und B2 werden jeweils Signale auf dem in Fig. 2 gezeigten Ausgang 40 ausgegeben. Zwischen den Betriebsmodi B1 und B2 kann über den in Fig. 2 gezeigten Eingang 50 umgeschaltet werden. Im ersten Betriebsmodus B1 wird über den Ausgang 40 eine Spannung ausgegeben, die der Breite W des Lackvorhangs 2 entspricht, und die von dem Sensor 30 erfasst wurde. Ist der Ausgang beispielsweise als Analogausgang realisiert, kann er ausgelegt sein, eine Spannung im Bereich von 0 bis 10 V auszugeben. In diesem Fall kann eine Spannung von 0 V anzeigen, dass kein Lackvorhang 2 vorhanden ist. Eine Ausgangsspannung von 10 V würde in diesem Fall bedeuten, dass sich der Lackvorhang 2 über die gesamte Breite WS des Sichtfeldes S erstreckt. Wäre beispielsweise die Breite WS des Sichtfeldes S 10 cm, wäre im Betriebsmodus B1 des in Fig. 4 dargestellten Beispiels die Ausgangsspannung am Analogausgang 40 1 V, d.h. die Breite W des Lackvorhangs 2 beträgt 1 cm. Üblicherweise werden Vorhangbreiten von 3 bis 20 mm verwendet. Entsprechend ist die Breite WS des Sichtfeldes S auf ca. 25 - 30 mm ausgelegt. In zukünftigen Anwendungen sind Abmessungen von weniger oder mehr als 3 cm denkbar. Im Betriebsmodus B2 wird die Mittenposition M des Lackvorhangs 2 bestimmt. Im Fall eines Analogausgangs kann auf dem Analogausgang 40 eine Spannung ausgegeben werden, die beispielsweise mit der Entfernung der Mittellage M des Lackvorhangs 2 vom Rand des Sichtfelds S korrespondiert. Beträgt wie in dem oben genannten Beispiel die Breite WS des Sichtfeldes S 10 cm und liegt der Spannungsbereich des analogen Ausgangssignals zwischen 0 V und 10 V, entspräche eine Mittenposition M des Lackvorhangs 2 in der Darstellung von Fig. 4 einer Ausgangsspannung von ca. 5 V am analogen Ausgang 40. Es sind jedoch auch andere Skalierungen möglich, beispielsweise bei einer exakten Mittenposition könnte die Ausgangsspannung 0 V betragen und bei einer Verschiebung der Mittellage M des Lackvorhangs 2 an den linken Rand des Sichtfeldes könnte zu einer Ausgangsspannung von -5 V führen und eine Verschiebung der Mittellage M an den rechten Rand des Sichtfeldes S könnte zu einer Ausgangsspannung von +5 V führen. Auch die Ausgangsspannungsspanne von 10 V ist nicht auf diesen Wert beschränkt, sondern kann einen beliebigen Wert, wie beispielsweise 3 V oder 5 V, annehmen. Anstelle der Analogspannungen können auch Digitalwerte ausgegeben werden. Die beiden Betriebsmodi B1 und B2 können bei zwei Ausgängen gleichzeitig ausgeführt und deren Ergebnisse auf den beiden Ausgängen ausgegeben werden. Bei nur einem Ausgang kann über den Digitaleingang 50 zwischen den beiden Betriebsmodi umgeschaltet werden. Erfindungsgemäß werden die beiden Betriebsmodi bei zwei Ausgängen gleichzeitig ausgeführt und deren Ergebnisse auf den beiden Ausgängen ausgegeben.

In der Regel ist die Messposition, also die Mittenposition P der Vorhangdüse 1 auf die Mittenposition des Sichtfeldes S des Sensors 30 eingestellt. Das heißt, die Mittellage P der Vorhangdüse 1 in der Messposition entspricht in dem oben gewählten Beispiel mit Analogausgang einer Ausgangsspannung des Sensors 30 im zweiten Betriebsmodus B2 von 5 V, wenn 0 V der linken Randposition des Sichtfeldes entspräche, und 10 V dem rechten Rand des Sichtfeldes S entspräche. Bei exakter Symmetrie des Lackvorhangs 2 muss die Ausgangsspannung des Analogausgangs 40 im zweiten Betriebsmodus B2 einem fiktiven Spannungswert für die Vorhangdüsenposition entsprechen, der der Mittenposition P der Vorhangdüse 1 entspricht.

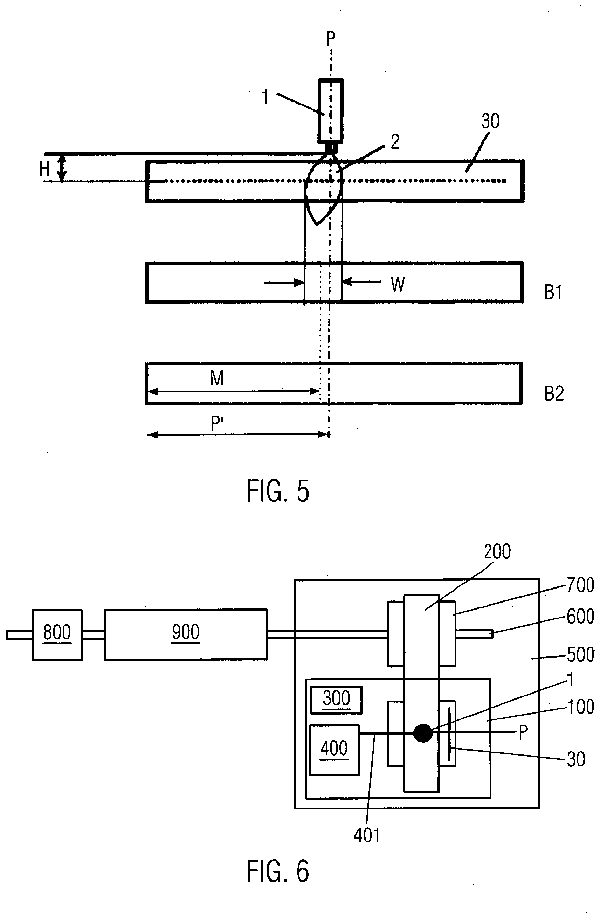

Fig. 5 veranschaulicht die Situation bei einer Unsymmetrie des Lackvorhangs 2. In diesem Fall ergeben sich unterschiedliche Werte für die Koordinate P der Mittelposition der Vorhangdüse 1, der ein virtueller Spannungswert P' zugeordnet werden kann und der Mittellage M des Lackvorhangs 2. Aus der Differenz der beiden Koordinatenwerte kann eine Korrektur für das Sprühmuster bei der Lackbeschichtung berechnet werden. Durch die feste Zuordnung der Positionen des Sichtfeldes S und der Vorhangdüse 1 lässt sich jedem Koordinatenwert innerhalb des Sichtfeldes S des Sensors 30 ein Spannungswert am analogen Ausgang 40 zuordnen, sodass die ausgegebene Spannung am Analogausgang 40 im Betriebsmodus B2 immer in Bezug zur Position der Vorhangdüse 1 auf der Y-Achse steht.

Fig. 6 zeigt schematisch eine Platinenfertigungsanlage mit einigen ausgewählten Komponenten. Mit Bezugszeichen 100 wird eine Messvorrichtung bezeichnet. Das Bezugszeichen 200 bezeichnet eine Transportvorrichtung für eine Vorhangdüse 1. Das Bezugszeichen 300 bezeichnet eine Steuerung und das Bezugszeichen 400 bezeichnet eine Lackversorgungseinrichtung mit Pumpen und Lackreservoirs. Über die Versorgungsleitung 401 wird der Lack aus der Lackversorgungseinrichtung der Vorhangdüse 1 zugeführt. In Fig. 6 ist die Vorhangdüse 1 in einer Position gegenüber dem Sensor 30 in einer Messposition P gezeichnet. Mit der Transportvorrichtung 200 kann der Lackapplikator 1 von der Messposition P zu einem Lackierabschnitt 700 transportiert werden. Eine Platinenfördereinrichtung 600 befördert Platinen zwischen verschiedene Verarbeitungsstufen, beispielsweise von einer Bestückungseinrichtung 800 durch einen Ofen 900 in den Lackierabschnitt 700. Das Bezugszeichen 500 bezeichnet eine Lackiervorrichtung für Platinen.

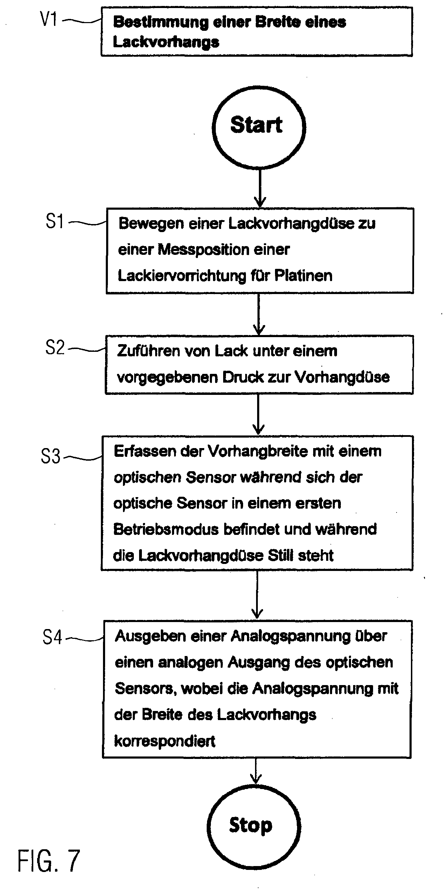

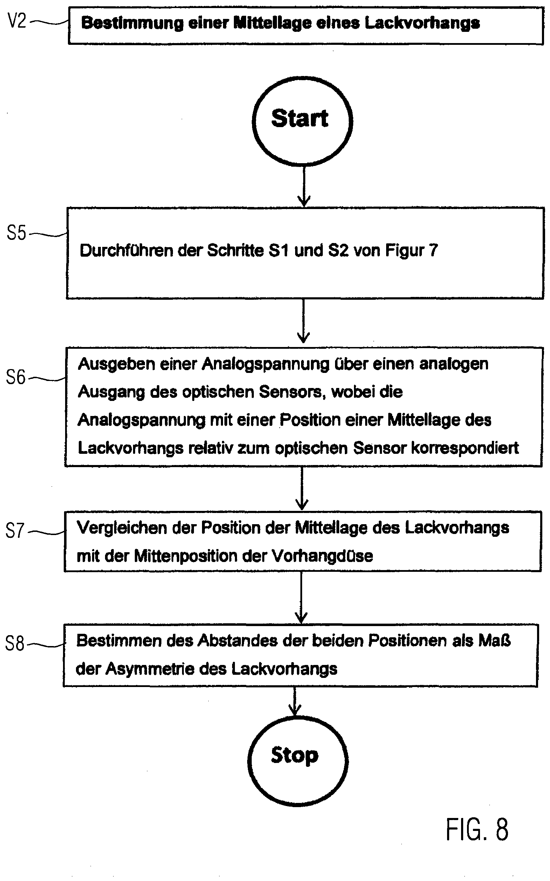

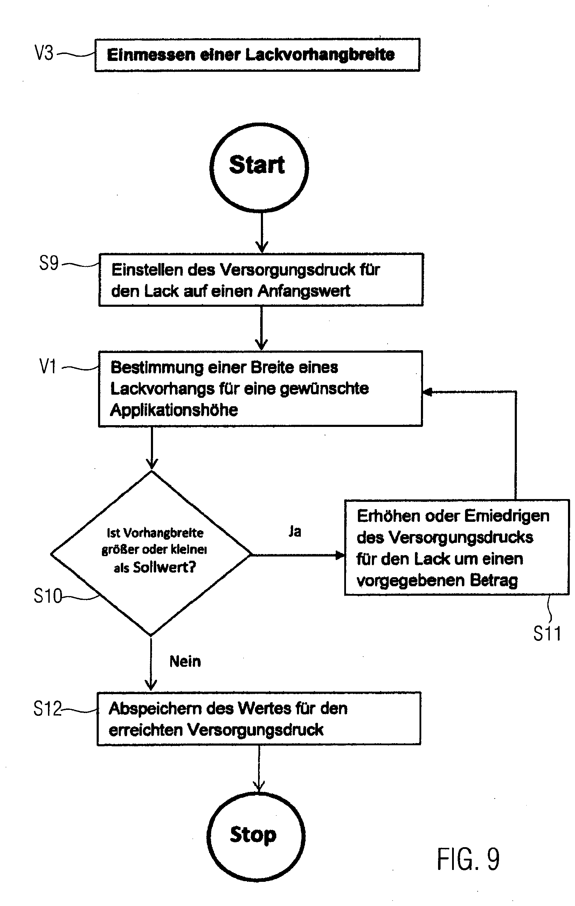

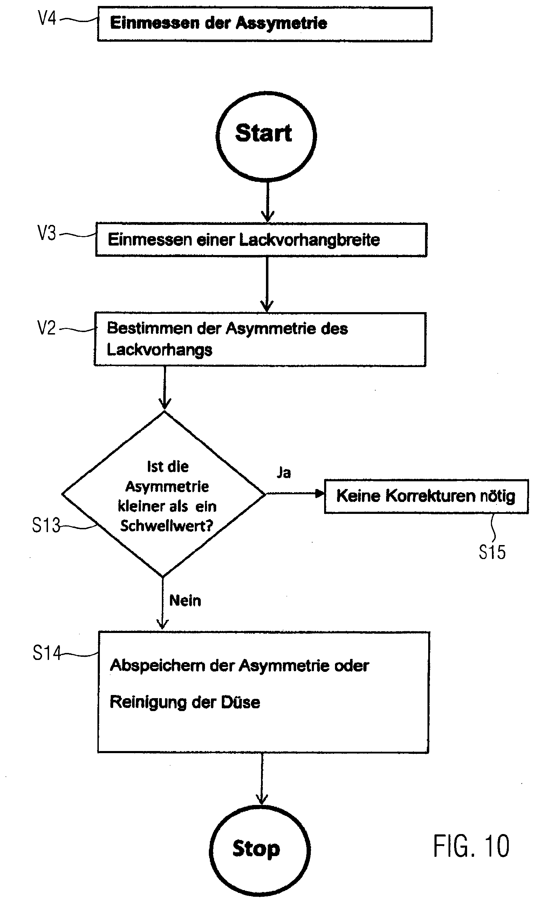

Die Figuren 7 bis 10 zeigen Flußdiagramme für verschiedene Verfahren zur Verwendung der vorher beschriebenen Anordnungen und Prinzipien. Die Figuren 7 und 8 veranschaulichen dabei die grundsätzlichen Messverfahren für die Bestimmung der Breite und der Symmetrie eines Lackstrahls. Diese beiden Verfahren können als Bausteine in den Verfahren der Figuren 9 und 10 verwendet werden, oder alleine verwendet werden, beispielsweise in einem Breitencheck oder einem Symmetriecheck, die regelmäßig durchgeführt werden können. Die Verfahren werden am Beispiel des vorher beschriebenen Sensors mit einem Analogausgang beschrieben; erfindungsgemäß werden die Verfahren mit mehreren digitalen oder analogen Ausgängen durchgeführt und sie können mit mehreren digitalen oder analogen Eingängen durchgeführt werden. Weiterhin können die beschriebenen Verfahren in beliebiger Reihenfolge kombiniert werden. Die in den Flussdiagrammen von Fig. 7 bis 10 veranschaulichten Verfahren sind nur beispielhafte Ausführungsformen, die nur Teilaspekte der beiliegenden Ansprüche verdeutlichen und die nicht als einschränkend betrachtet werden dürfen. Der Gesamtumfang der Erfindung wird ausschließlich durch die beiliegenden Ansprüche definiert.

Fig. 7 veranschaulicht ein Verfahren zur Verwendung des vorher besprochenen Sensors. Fig. 2 zeigt ein Verfahren zur Bestimmung einer Breite eines Lackvorhangs V1. Im Schritt S1 wird eine Lackvorhangdüse zu einer Messposition einer Lackiervorrichtung für Platinen bewegt. Im nächsten Schritt S2 wird Lack unter einem vorgegebenen Druck zur Vorhangdüse zugeführt. Im nächsten Schritt S3 wird die Vorhangbreite mit dem vorher beschriebenen optischen Sensor 30 erfasst, während sich der optische Sensor in einem ersten Betriebsmodus befindet und während die Lackvorhangdüse stillsteht. Im Schritt S4 wird über den analogen Ausgang 40 des optischen Sensors 30 eine Analogspannung ausgegeben, wobei die Analogspannung mit der Breite des Lackvorhangs korrespondiert.

Fig. 8 zeigt ein Flussdiagramm für ein Verfahren zur Bestimmung einer Mittellage eines Lackvorhangs V2. Im Schritt S5 werden die Schritte S1 und S2 aus der Figur 7 durchgeführt. Alternativ könnte im unmittelbaren Anschluss an das Verfahren von Fig. 7 der Betriebsmodus umgeschaltet werden, beispielsweise über einen digitalen Eingang 50. In diesem Fall kann in den digitalen Eingang 50 des optischen Sensors 30 ein digitales Signal eingegeben werden, um den optischen Sensor 30 in einen zweiten Betriebsmodus B2 zu versetzen. Bei zwei Ausgängen könnte dieser Schritt vollständig entfallen. Im nächsten Schritt S6 wird ein über einen analogen Ausgang 40 des optischen Sensors 30 eine Analogspannung ausgegeben, wobei die Analogspannung mit einer Position einer Mittellage M des Lackvorhangs 2 relativ zum optischen Sensor 30 korrespondiert. Im nächsten Schritt S7 wird die Position der Mittellage M des Lackvorhangs 2 mit der Mittenposition P der Vorhangdüse 1 an der Messposition verglichen. Wie vorher beschrieben wurde, ist die Mittenposition der Vorhangdüse relativ zum Sensor 30 bekannt und kann als virtuelles Spannungssignal beispielsweise in einer Gerätesteuerung abgespeichert sein. Der gemessene Spannungswert für die Mittellage M des Lackvorhangs 2 wird in Form eines Analogsignals am Analogausgang 40 ausgegeben. Dieser ausgegebene Wert kann mit dem abgespeicherten virtuellen Spannungswert T', der die Lage der Vorhangdüse relativ zum Sichtfeld S des Sensors 30 definiert, vergleichen werden. Im nächsten Schritt S8 wird ein Abstand zwischen den beiden Positionen als Maß der Asymmetrie des Lackvorhangs bestimmt.

Fig. 9 zeigt ein Flussdiagramm für ein Verfahren V3 zum Einmessen einer Vorhangbreite. Im Schritt S9 wird der Versorgungsdruck für den Lack auf einen Anfangswert eingestellt. Im nächsten Schritt wird das Verfahren V1, das in Fig. 7 beschrieben wurde, mit den Schritten S1 bis S4 durchgeführt. Im Schritt S10 wird die gemessene Vorhangbreite mit einem Sollwert verglichen. Ist die gemessene Vorhangbreite kleiner als der Sollwert, wird im Schritt S11 der Versorgungsdruck für den Lack um einen vorgegebenen Betrag erhöht. Umgekehrt, ist die gemessene Vorhangbreite größer als der Sollwert, wird im Schritt S11 der Versorgungsdruck für den Lack um einen vorgegebenen Betrag erniedrigt. Danach wird mit dem Verfahren V1 mit den Schritten S1 bis S4 fortgefahren. Entspricht die gemessene Vorhangbreite dem Sollwert, wird im Schritt S12 der Wert für den erreichten Versorgungsdruck abgespeichert.

Fig. 10 zeigt ein Flussdiagramm V4 für ein Verfahren zum Einmessen einer Vorhangbreite. Dieses Verfahren kann optional im Anschluss des Verfahrens V3 von Fig. 9 durchgeführt werden. Anschließend wird die Asymmetrie gemäß dem Verfahren V2 von Fig. 8 durchgeführt. Im Schritt S13 wird die gemessene Asymmetrie mit einem Schwellwert verglichen. Ist der Asymmetriewert kleiner als ein erster Schwellwert, sind keine Korrekturen nötig. Ist der Asymmetriewert größer als ein erster Schwellwert, werden mit dem Asymmetriewert Korrekturen im Lackierplan durchgeführt. Ist der Asymmetriewert größer als ein zweiter Schwellwert, kann die Düse gereinigt werden. Obwohl Fig. 10 ein Verfahren beschreibt, in dem im ersten Schritt das Verfahren V3 von Fig. 9 ausgeführt wird, kann das Verfahren auch ohne diesen Schritt ausgeführt werden. Dieses letztgenannte Verfahren kann dann als erster Schritt im Verfahren nach Fig. 9 ausgeführt werden. D.h., im Einmessvorgang kann die Bestimmung der Symmetrie vor der Bestimmung der Breite ausgeführt werden.

Nachdem die Parameter für die gewünschte Vorhangbreite in der gewünschten Applikationshöhe, d.h. die erforderlichen Druckwerte, sowie die Asymmetrie des Lackvorhangs bekannt sind, kann im nächsten Schritt die Maschinensteuerung ein Programm für ein Sprühmuster zum Beschichten der Platinen berechnen oder anpassen und anschließend den Beschichtungsvorgang durchführen.

## Patentansprüche

1. Lackiervorrichtung (500) für Platinen, die umfasst:
eine Messvorrichtung (100) mit einem optischen Sensor (30), und
einen Lackierabschnitt (700), in dem die Platinen lackiert werden können,
wobei der optische Sensor (30) umfasst:
ein Sichtfeld (S), das eine Breitenausdehnung (SW) aufweist, die größer ist als die maximal zu erwartende Breite (W) des Lackstrahls, so dass der Sensor relativ zum Lackstrahl während des Messvorgangs nicht bewegt werden muss,
wobei der optische Sensor (30) einen ersten Betriebsmodus (B1) und einen zweiten Betriebsmodus (B2) aufweist, wobei im ersten Betriebsmodus (B1) über den mindestens einen Ausgang (40) ein Signal ausgegeben werden kann, das mit einer Breite (W) des Lackstrahls im Sichtfeld (S) des optischen Sensors korrespondiert, und wobei im zweiten Betriebsmodus (B2) über den mindestens einen Ausgang (40) ein Signal ausgegeben werden kann, das mit einer Position einer Mittellage (M) des Lackstrahls relativ zum optischen Sensor korrespondiert, und
wobei der optische Sensor mindestens zwei Ausgänge aufweist, wobei auf dem ersten der mindestens zwei Ausgänge ein Signal ausgegeben werden kann, das mit der Breite (W) des Lackstrahls im Sichtfeld (S) des optischen Sensors korrespondiert und auf dem zweiten der mindestens zwei Ausgänge ein Signal ausgegeben werden kann, das mit der Position der Mittellage (M) des Lackstrahls relativ zum optischen Sensor korrespondiert
wobei die Messvorrichtung (100) umfasst:
den optischen Sensor (30);
eine Positioniervorrichtung (200), die zum Positionieren eines Lackapplikators für das Beschichten von Platinen mit Schutzlack angepasst ist; und
eine Steuerungseinrichtung (300), die konfiguriert ist, die Positioniervorrichtung so zu steuern, dass der Lackapplikator an eine vorgegebene Messposition befördert wird, so dass ein Lackaustritt aus einer Düsenmündung in dem Lackapplikator in einer vorgegebenen Applikationshöhe oberhalb des Sichtfeldes des Sensors positioniert wird, und eine Lackstrahlbreite und/oder eine Lackstrahlsymmetrie des Lackstrahls in der vorgegebenen Applikationshöhe gemessen werden kann,
wobei die Messvorrichtung weiterhin eine Lackversorgungseinrichtung für den Lackapplikator umfasst, und
wobei die Steuerungseinrichtung (300) weiterhin konfiguriert ist, die Lackversorgungseinrichtung anzusteuern, so dass die Lackstrahlbreite und/oder die Lackstrahlsymmetrie des Lackstrahls bei einem bestimmten Versorgungsdruck für den Lack bestimmt werden kann,
wobei die Positioniervorrichtung der Messvorrichtung weiterhin konfiguriert ist, den Lackapplikator in den Lackierbereich zu positionieren und im Lackierbereich so zu bewegen, dass die Platine lackiert wird, und
wobei die Steuerungseinrichtung (300) der Messvorrichtung weiterhin konfiguriert ist, die Positioniervorrichtung und die Lackversorgungseinrichtung für einen Lackiervorgang unter Verwendung der gemessenen Lackstrahlbreite und/oder Lackstrahlsymmetrie zu steuern.

2. Lackiervorrichtung (500) nach Anspruch 1, wobei der optische Sensor einen Eingang (50) aufweist, über den der Betriebsmodus ausgewählt werden kann.

3. Lackiervorrichtung (500) nach einem der Ansprüche 1 bis 2, wobei die Breitenausdehnung (SW) des Sichtfelds des optischen Sensors im Bereich zwischen 4 cm und 1 cm liegt, vorzugsweise im Bereich von 3 cm liegt.

4. Lackiervorrichtung (500) nach einem der Ansprüche 1 bis 3, wobei der optische Sensor Licht in einem Wellenlängenbereich von 650 nm bis 780 nm, vorzugsweise in einem Bereich um 670 nm verwendet.

5. Lackiervorrichtung (500) nach einem der Ansprüche 1 bis 4, wobei die Lackiervorrichtung (500) weiterhin eine Platinenfördereinrichtung (600) umfasst.

6. Verfahren zum Betreiben der Lackiervorrichtung gemäß Anspruch 1, das folgende Schritte umfasst:
Bestimmung (V1) einer Breite eines Lackstrahls zum Beschichten von Platinen;
Bestimmung (V2) einer Symmetrie eines Lackstrahls zum Beschichten von Platinen;
Einmessen (V3) der Breite des Lackstrahls; und
Einmessen (V4) der Asymmetrie des Lackstrahls.

7. Verfahren nach Anspruch 6, wobei die Bestimmung (V1) der Breite eines Lackstrahls zum Beschichten von Platinen die folgenden Schritte umfasst:
Bewegen des Lackapplikators zu einer Messposition der Lackiervorrichtung für Platinen (S1);
Zuführen von Lack unter einem vorgegebenen Druck zum Lackapplikator(S2);
Erfassen der Lackstrahlbreite mit dem optischen Sensor während der Lackapplikator still steht (S3); und
Ausgeben eines ersten Signals, das mit der Breite des Lackstrahls korrespondiert (S4).

8. Verfahren nach Anspruch 6 oder 7, wobei die Bestimmung der Symmetrie eines Lackstrahls zum Beschichten von Platinen (V2) die folgenden Schritte umfasst:
Bewegen des Lackapplikators zu einer Messposition der Lackiervorrichtung für Platinen (S1);
Zuführen von Lack unter einem vorgegebenen Druck zum Lackapplikator (S2);
Erfassen einer Mittellage des Lackstrahls relativ zum optischen Sensor mit dem optischen Sensor, während der Lackapplikator still steht (S3);
Ausgeben eines zweiten Signals, das mit einer Position einer Mittellage des Lackstrahls relativ zum optischen Sensor korrespondiert (S6);
Vergleichen der Position der Mittellage des Lackstrahls mit der Mittenposition einer Düsenmündung am Lackapplikator (S7); und
Bestimmen des Abstandes der beiden Positionen als Maß der Asymmetrie des Lackvorhangs (S8).

9. Verfahren (V1, V2) nach Anspruch 6, 7 oder 8, wobei der Lackapplikator so an der Messposition positioniert wird, dass ein Lackaustritt aus einer Düsenmündung im Lackapplikator in einer vorgegebenen Applikationshöhe oberhalb eines Sichtfeldes des Sensors positioniert wird, und eine Lackstrahlbreite und eine Strahlsymmetrie des Lackstrahls in der vorgegebenen Applikationshöhe gemessen werden kann.

10. Verfahren nach Anspruch 6, wobei das Einmessen der Breite des Lackstrahls (V3) die folgenden Schritte umfasst:
(a) Einstellen des Versorgungsdrucks für den Lack auf einen Anfangswert (S9);
(b) Bestimmung einer Breite eines Lackstrahls für eine gewünschte Applikationshöhe gemäß Anspruch 7 (V1);
(c) Vergleich der gemessenen Lackstrahlbreite mit einem Sollwert (S10, S12);
(d) Anpassen des Versorgungsdrucks für den Lack um einen vorgegebenen Betrag, wenn die gemessene Lackstrahlbreite nicht der Solllackstrahlbreite entspricht (S11, S13);
(e) Wiederholen der Schritte (b) bis (d) bis die Solllackstrahlbreite erreicht ist; und
(f) Abspeichern des Wertes für den erreichten Versorgungsdruck (S12).

11. Verfahren nach Anspruch 6, wobei das Einmessen einer Asymmetrie des Lackstrahls folgende Schritte umfasst:
(g) Bestimmen der Asymmetrie des Lackstrahls gemäß Anspruch 8 (V2); und
(h) Abspeichern der Asymmetrie in Form eines Wertes für einen Versatz zwischen der Position der Mittellage des Lackstrahls und der Mittenposition Düsenmündung am Lackapplikator.

12. Verfahren nach Anspruch 6, wobei das Einmessen der Asymmetrie des Lackstrahls folgende Schritte umfasst:
(g) Bestimmen der Asymmetrie des Lackstrahls gemäß Anspruch 8 (V2);
(i) Vergleich des Abstandes zwischen der Position der Mittellage des Lackstrahls und der Mittenposition der Düsenmündung am Lackapplikator mit einem ersten Schwellwert (S13); und
(j) Abspeichern der Asymmetrie in Form eines Wertes für einen Versatz zwischen der Position der Mittellage des Lackstrahls und der Mittenposition Düsenmündung am Lackapplikator (S14), wenn der erste Schwellwert überschritten wird.

13. Verfahren nach Anspruch 11 oder 12, das weiterhin die folgenden Schritte umfasst:
(k) Vergleich des Abstandes zwischen der Position der Mittellage des Lackvorhangs und der Mittenposition der Düsenmündung am Lackapplikator mit einem zweiten Schwellwert;
(l) Positionieren des Lackapplikators in eine Reinigungsposition und Durchführen einer Reinigung, wenn der Schwellwert überschritten wird.

## Claims

1. A varnishing device (500) for circuit boards comprising:
a measuring device (100) including an optical sensor (30); and
a varnishing section (700) in which the circuit boards can be varnished,
wherein the optical sensor (30) comprises:
a field of view (S) having a width extension (SW) greater than the maximum expected width (W) of the varnish jet so that the sensor does not need to be moved relative to the varnish jet during the measurement operation;
wherein the optical sensor has a first operating mode (B1) and a second operating mode (B2), wherein in the first operating mode (B1), a signal can be output via the at least one output (40), said signal corresponding to a width (W) of the varnish jet in the field of view (S) of the optical sensor, and wherein, in the second operating mode (B2), a signal can be output via the at least one output (40) which corresponds to a position of a central position (M) of the varnish jet relative to the optical sensor,
the optical sensor has at least two outputs, wherein on the first of the at least two outputs a signal can be output which corresponds to the width (W) of the varnish jet in the field of view (S) of the optical sensor and on the second of the at least two outputs a signal can be output which corresponds to the position of the center position (M) of the varnish jet relative to the optical sensor,
wherein the measuring device (100) comprises:
the optical sensor (30);
a positioning device (200) adapted to position a varnish applicator for varnishing circuit boards with a protective varnish; and
control means (300) configured to control the positioning device such that the varnish applicator is conveyed to a predetermined measuring position such that a varnish exit from a nozzle orifice in the varnish applicator is positioned at a predetermined application height above the field of view of the sensor, and a varnish jet width and/or a varnish jet symmetry of the varnish jet can be measured at the predetermined application height,
wherein the measuring device further comprises a varnish supply means for the varnish applicator, and
wherein the control means (300) is further configured to drive the varnish supply means so that the varnish jet width and/or the varnish jet symmetry of the varnish jet can be determined at a particular supply pressure for the varnish,
wherein the positioning device of the measuring device being further configured to position the varnish applicator in the varnishing section and to move it in the varnishing section so that the circuit board is varnished, and
wherein the control means (300) of the measuring device is further configured to control the positioning device and the varnish supply means for a varnishing operation using the measured varnish jet width and/or varnish jet symmetry.

2. The varnishing device (500) according to claim 1, wherein the optical sensor has an input (50) through which the operating mode can be selected.

3. The varnishing device (500) according to any of claims 1 to 2, wherein the width extension (SW) of the field of view of the optical sensor is in the range between 4 cm and 1 cm, preferably in the range of 3 cm.

4. The varnishing device (500) according to any of claims 1 to 3, wherein the optical sensor uses light in a wavelength range of 650 nm to 780 nm, preferably in a range around 670 nm.

5. The varnishing device (500) according to any of claims 1 to 4, wherein the varnishing device (500) further comprises a circuit board conveyor (600).

6. A method of operating the varnishing device (500) according to claim 1, comprising the following steps:
determining (V1) a width of a varnish jet for coating circuit boards;
determining (V2) a symmetry of the varnish jet for coating circuit boards;
measuring (V3) a width of the varnish jet; and
measuring (V4) an asymmetry of the varnish jet.

7. The method according to claim 6, wherein the determining (V1) a width of a varnish jet for coating circuit boards, comprising the steps of:
moving a varnish applicator to a measuring position of a varnishing device for printed circuit boards (S1);
supplying varnish under a predetermined pressure to the varnish applicator (S2);
detecting the varnish jet width with an optical sensor according to one of claims 1 - 7 while the varnish applicator is stationary (S3); and
outputting a first signal corresponding to the width of the varnish jet (S4).

8. The method according to claim 6 or 7, wherein determining a symmetry of a varnish jet for coating circuit boards (V2) comprising:
moving a varnish applicator to a measuring position of a varnishing device for printed circuit boards (S1);
supplying varnish under a predetermined pressure to the varnish applicator (S2);
detecting a center position of the varnish jet relative to the optical sensor having an optical sensor according to one of claims 1 - 7 while the varnish applicator is stationary ( S3);
outputting a second signal corresponding to a position of a center position of the varnish jet relative to the optical sensor (S6);
comparing the position of the center position of the varnish jet with the center position of a nozzle orifice on the varnish applicator (S7); and
determining the distance of the two positions as a measure of the asymmetry of the varnish curtain (S8).

9. The method (V1, V2) according to claim 6, 7 or 8, wherein the varnish applicator is positioned at the measuring position such that a varnish outlet from a nozzle orifice in the varnish applicator is positioned at a predetermined application height above a field of view of the sensor, and a varnish jet width and a jet symmetry of the varnish jet can be measured at the predetermined application height.

10. The method according to claim 6, wherein the measuring a varnish jet width (V3) comprising the steps of:
(a) adjusting the supply pressure for the varnish to an initial value (S9);
(b) determining a width of a varnish jet for a desired application height according to claim 7 (V1);
(c) comparing the measured varnish jet width with a target value (S10, S12);
(d) adjusting the supply pressure for the varnish by a predetermined amount if the measured varnish jet width does not correspond to the target varnish jet width (S11, S13);
(e) repeating steps (b) to (d) until the desired varnish jet width is reached; and
(f) storing the value for the achieved supply pressure (S12).

11. The method according to claim 6, wherein the measuring a varnish jet asymmetry comprising the steps of:
(g) determining the asymmetry of the varnish jet according to claim 8 (V2); and
(h) storing the asymmetry in the form of a value for an offset between the position of the center position of the varnish jet and the center position of the nozzle orifice on the varnish applicator.

12. The method according to claim 6, wherein the measuring a varnish jet asymmetry comprising the steps of:
(g) determining the asymmetry of the varnish jet according to claim 8 (V2);
(i) comparing the distance between the position of the center position of the varnish jet and the center position of the nozzle orifice on the varnish applicator with a first threshold (S13); and
(j) storing the asymmetry in the form of a value for offset between the center position of the varnish jet and the center position of the nozzle orifice on the varnish applicator (S14) when the first threshold is exceeded.

13. The method according to claim 11 or 12, wherein the measuring a varnish jet asymmetry further comprises the following steps:
(k) comparing the distance between the center position of the varnish curtain and the center position of the nozzle orifice on the varnish applicator to a second threshold;
(l) positioning the varnish applicator in a cleaning position and performing a cleaning when the threshold is exceeded.

## Revendications

1. Dispositif de vernissage (500) pour cartes de circuit imprimé, comprenant :
un dispositif de mesure (100) muni d'un capteur optique (30) ; et
une section de vernissage (700) au sein de laquelle les cartes de circuit imprimé peuvent être vernies,
dans lequel le capteur optique (30) comprend :
un champ de vision (S) présentant une expansion en largeur (SW) supérieure à la largeur (W) maximale attendue du jet de vernis, de sorte que le capteur n'a pas besoin d'être déplacé par rapport au jet de vernis pendant l'opération de mesure,
dans lequel le capteur optique (30) présente un premier mode de fonctionnement (B1) et un deuxième mode de fonctionnement (B2), dans lequel, dans le premier mode de fonctionnement (B1), un signal correspondant à une largeur (W) du jet de vernis dans le champ de vision (S) du capteur optique peut être émis par l'intermédiaire de la au moins une sortie (40), et dans lequel, dans le deuxième mode de fonctionnement (B2), un signal correspondant à une position d'une couche médiane (M) du jet de vernis par rapport au capteur optique peut être émis par l'intermédiaire de la au moins une sortie (40), et
dans lequel le capteur optique présente au moins deux sorties, dans lequel un signal correspondant à la largeur (W) du jet de vernis dans le champ de vision (S) du capteur optique peut être émis sur la première des au moins deux sorties, et un signal correspondant à la position de la couche médiane (M) du jet de vernis par rapport au capteur optique peut être émis sur la deuxième des au moins deux sorties
dans lequel le dispositif de mesure (100) comprend :
le capteur optique (30) ;
un dispositif de positionnement (200) convenant pour le positionnement d'un applicateur de vernis destiné au revêtement de cartes de circuit imprimé avec un vernis de protection ; et
un dispositif de commande (300) configuré pour commander le dispositif de positionnement de sorte que l'applicateur de vernis est transporté vers une position de mesure prédéfinie, de sorte qu'une sortie de vernis issue d'un orifice de buse est positionnée dans l'applicateur de vernis à une hauteur d'application prédéfinie au-dessus du champ de vision du capteur, et de sorte qu'une largeur de jet de vernis et/ou une symétrie de jet de vernis du jet de vernis peu(ven)t être mesurée(s) à la hauteur d'application prédéfinie,
dans lequel le dispositif de mesure comprend en outre un dispositif d'alimentation en vernis destiné à l'applicateur de vernis, et
dans lequel le dispositif de commande (300) est en outre configuré pour commander le dispositif d'alimentation en vernis, de sorte que la largeur de jet de vernis et/ou la symétrie de jet de vernis du jet de vernis peu(ven)t être déterminée(s) pour une pression d'alimentation déterminée du vernis,
dans lequel le dispositif de positionnement du dispositif de mesure est en outre configuré pour positionner l'applicateur de vernis dans la région de vernissage et pour le déplacer dans la région de vernissage de manière à vernir la carte de circuit imprimé, et
dans lequel le dispositif de commande (300) du dispositif de mesure est en outre configuré pour commander le dispositif de positionnement et le dispositif d'alimentation en vernis en vue d'une opération de vernissage en utilisant la largeur de jet de vernis et/ou la symétrie de jet de vernis mesurée(s).

2. Dispositif de vernissage (500) selon la revendication 1, dans lequel le capteur optique présente une entrée (50) par l'intermédiaire de laquelle le mode de fonctionnement peut être sélectionné.

3. Dispositif de vernissage (500) selon la revendication 1 ou 2, dans lequel l'expansion en largeur (SW) du champ de vision du capteur optique se situe dans la plage comprise entre 4 cm et 1 cm, de manière préférée autour de 3 cm.

4. Dispositif de vernissage (500) selon l'une quelconque des revendications 1 à 3, dans lequel le capteur optique utilise de la lumière dans une plage de longueurs d'onde comprise entre 650 nm et 780 nm, de manière préférée située autour de 670 nm.

5. Dispositif de vernissage (500) selon l'une quelconque des revendications 1 à 4, dans lequel le dispositif de vernissage (500) comprend en outre un convoyeur de cartes de circuit imprimé (600).

6. Procédé de fonctionnement du dispositif de vernissage selon la revendication 1, comprenant les étapes ci-dessous consistant à :
déterminer (V1) une largeur d'un jet de vernis destiné au revêtement de cartes de circuit imprimé ;
déterminer (V2) une symétrie d'un jet de vernis destiné au revêtement de cartes de circuit imprimé ;
mesurer (V3) la largeur du jet de vernis ; et
mesurer (V4) l'asymétrie du jet de vernis.

7. Procédé selon la revendication 6, dans lequel l'étape de détermination (V1) de la largeur d'un jet de vernis destiné au revêtement des cartes de circuit imprimé comprend les étapes ci-dessous consistant à :
déplacer (S1) l'applicateur de vernis vers une position de mesure du dispositif de vernissage pour cartes de circuit imprimé ;
fournir (S2) du vernis à l'applicateur de vernis sous une pression prédéfinie ;
détecter (S3) la largeur de jet de vernis avec le capteur optique lorsque l'applicateur de vernis est à l'arrêt ; et
émettre (S4) un premier signal correspondant à la largeur du jet de vernis.

8. Procédé selon la revendication 6 ou 7, dans lequel l'étape de détermination (V2) de la symétrie d'un jet de vernis destiné au revêtement des cartes de circuit imprimé comprend les étapes ci-dessous consistant à :
déplacer (S1) l'applicateur de vernis vers une position de mesure du dispositif de vernissage pour cartes de circuit imprimé ;
fournir (S2) du vernis à l'applicateur de vernis sous une pression prédéfinie ;
détecter (S3) une couche médiane du jet de vernis par rapport au capteur optique, à l'aide du capteur optique lorsque l'applicateur de vernis est à l'arrêt ;
émettre (S6) un second signal correspondant à une position d'une couche médiane du jet de vernis par rapport au capteur optique ;
comparer(S7) la position de la couche médiane du jet de vernis avec la position médiane d'un orifice de buse au niveau de l'applicateur de vernis ; et
déterminer (S8) la distance entre les deux positions en tant que mesure de l'asymétrie du rideau de vernis.

9. Procédé (V1, V2) selon la revendication 6, 7 ou 8, dans lequel l'applicateur de vernis est positionné au niveau de la position de mesure de sorte qu'une sortie de vernis issue d'un orifice de buse est positionnée dans l'applicateur de vernis à une hauteur d'application prédéfinie au-dessus d'un champ de vision du capteur, et une largeur de jet de vernis et une symétrie de jet du jet de vernis peuvent être mesurées à la hauteur d'application prédéfinie.

10. Procédé selon la revendication 6, dans lequel l'étape de mesure (V3) de la largeur du jet de vernis comprend les étapes ci-dessous consistant à :
(a) ajuster (S9) la pression d'alimentation du vernis à une valeur initiale ;
(b) déterminer (V1) une largeur d'un jet de vernis pour une hauteur d'application souhaitée selon la revendication 7 ;
(c) comparer (S10, S12) la largeur de jet de vernis mesurée avec une valeur de consigne ;
(d) adapter (S11, S13) la pression d'alimentation du vernis à concurrence d'une quantité prédéfinie si la largeur de jet de vernis mesurée ne correspond pas à la largeur de jet de vernis de consigne,
(e) répéter les étapes (b) à (d) jusqu'à ce que la largeur de jet de vernis de consigne soit atteinte ; et
(f) enregistrer (S12) la valeur de la pression d'alimentation atteinte.

11. Procédé selon la revendication 6, dans lequel la mesure d'une asymétrie du jet de vernis comprend les étapes ci-dessous consistant à :
(g) déterminer (V2) l'asymétrie du jet de vernis selon la revendication 8 ; et
(h) enregistrer l'asymétrie sous la forme d'une valeur d'un décalage entre la position de la couche médiane du jet de vernis et la position médiane de l'orifice de buse au niveau de l'applicateur de vernis.

12. Procédé selon la revendication 6, dans lequel la mesure de l'asymétrie du jet de vernis comprend les étapes ci-dessous consistant à :
(g) déterminer (V2) l'asymétrie du jet de vernis selon la revendication 8 ;
(i) comparer (S13) la distance entre la position de la couche médiane du jet de vernis et la position médiane de l'orifice de buse au niveau de l'applicateur de vernis avec une première valeur de seuil ; et
(j) enregistrer (S14) l'asymétrie sous la forme d'une valeur d'un décalage entre la position de la couche médiane du jet de vernis et la position médiane de l'orifice de buse au niveau de l'applicateur de vernis si la première valeur de seuil est dépassée.

13. Procédé selon la revendication 11 ou 12, comprenant en outre les étapes ci-dessous consistant à :
(k) comparer la distance entre la position médiane du rideau de vernis et la position médiane de l'orifice de buse au niveau de l'applicateur de vernis avec une deuxième valeur de seuil ;
(i) positionner l'applicateur de vernis dans une position de nettoyage et mettre en oeuvre un nettoyage si la valeur de seuil est dépassée.
